# EUROPÄISCHE PATENTSCHRIFT

(11) **EP 3 770 621 B1**
(45) Veröffentlichungstag und Bekanntmachung des Hinweises auf die Patenterteilung: **06.09.2023**
(21) Anmeldenummer: 20177885.9
(22) Anmeldetag: 02.06.2020
(51) Int. Cl.: G01R 31/392

(54) **VERFAHREN UND VORRICHTUNG ZUR ERMITTLUNG DER RESTKAPAZITÄT EINER BATTERIE**
METHOD AND DEVICE FOR DETERMINING THE REMAINING CAPACITY OF A BATTERY
PROCÉDÉ ET DISPOSITIF DE DÉTERMINATION DE LA CAPACITÉ RESTANTE D'UNE BATTERIE

(30) Priorität: 25.07.2019 DE 102019211050
(43) Veröffentlichungstag der Anmeldung: 27.01.2021
(73) Patentinhaber: Volkswagen Aktiengesellschaft, 38440 Wolfsburg (DE)
(72) Erfinder: Quantmeyer, Florian, 38302 Wolfenbüttel (DE); Kühnlenz, Florian, 38476 Barwedel (DE)

(56) Entgegenhaltungen:
- WO-A2-2009/158226
- FR-A1- 3 044 773
- US-A1- 2012 296 586
- US-B1- 6 366 054
- US-B2- 9 244 132

## Beschreibung

Die Erfindung betrifft ein Verfahren und eine Vorrichtung zur Ermittlung der Restkapazität einer Batterie in einem Hybrid-Fahrzeug, insbesondere einem Mild-Hybrid-Fahrzeug.

In Elektro- und Hybridfahrzeugen eingesetzte elektrische Energiespeicher unterliegen einer zyklischen und kalendarischen Alterung. Dies äußert sich in einer sinkenden Restkapazität. Dies wird durch den sogenannten SOH (state of health) ausgedrückt, der das Verhältnis von Restkapazität zur Nennkapazität ist. Die Restkapazität ist für verschiedene Steuerungsalgorithmen im Batteriemanagementsystem die Grundlage und sollte daher überwacht bzw. bestimmt werden.

Unter Laborbedingungen lässt sich die Restkapazität mit einer hohen Genauigkeit bestimmen, indem die Batterie bis zur Maximalspannung aufgeladen wird (100 % SOC) und anschließend mit einem definierten Strom bis zu einer Minimalspannung (0 % SOC) entladen wird.

Im Fahrzeugeinsatz wird das Anlernen der Restkapazität durch zwei aufeinanderfolgende SOC-Bestimmungen durch OCV (Open-Circuit-Voltage) Messungen mit einem dazwischenliegenden Lade- oder Entladungsvorgang durchgeführt. Dabei wird der Strom während des Lade- und Entladungsvorganges zu einem Ladungsinhalt aufintegriert. Aus den SOC-Messungen ist der SOC-Hub bekannt und aus der Stromintegration die eingeladene oder entladene Ladung. Mittels dieser Kenngrößen des Verfahrens kann dann die Restkapazität bestimmt werden. Die Genauigkeit des Verfahrens setzt dabei ausreichend große SOC-Hübe voraus. Auch darf zwischen den OCV-Messungen nicht zuviel geladen und entladen werden, da sich die Fehler bei der Integration des Stromes aufsummieren. Insbesondere der ausreichende SOC-Hub ist bei Mild-Hybrid-Fahrzeugen ein Problem, da diese üblicherweise nur in einem engen SOC-Fenster betrieben werden. Bei Mild-Hybrid-Fahrzeugen wird die Batterie nur zum Boosten verwendet bzw. zur Aufnahme von Rekuperations-Energie beim Bremsen.

Weiter ist es bekannt, den SOH zu schätzen oder über Innenwiderstandsmessungen der Batterie zu bestimmen, was jedoch in beiden Fällen zu großen Ungenauigkeiten führt.

Aus der DE 10 2013 216 200 A1 ist ein Elektrofahrzeug bekannt, umfassend eine Steuerung, die zum Überwachen der Keyoff-Ereignisse und Schätzen der Batteriekapazität gemäß einer ersten Ladezustandsschätzung, einer Ladeintegration und einer zweiten Ladezustandsschätzung konfiguriert ist. Dabei entspricht die erste bzw. die zweite Ladezustandsschätzung dem ersten bzw. zweiten konsekutiven Keyoff-Ereignis und stimmt mit den Zeit- und Temperatureinschränkungen überein, sodass die Ladezustandsschätzungen auf den Batterie-Ruhespannungen basieren, wobei die Steuerung ferner zum Erzeugen einer Ausgabe basierend auf der geschätzten Batteriekapazität konfiguriert ist.

Aus der EP 3 011 351 B1 ist ein Verfahren zur Schätzung von Alterungszustands(SOH)-Eigenschaften einer Batterie in Hybridfahrzeugen bekannt, umfassend die Schritte:
- Laden und Entladen der Batterie wenigstens einmal innerhalb eines oberen Bereichs eines Ladezustands(SOC)-Fensters, wobei die Batterie:
   i) während einer ersten Zeitspanne auf ein erstes vorgegebenes Niveau im oberen Bereich des SOC-Fensters geladen wird;
   ii) während einer zweiten Zeitspanne durch einen ersten Ladestromimpuls geladen wird, um das SOC-Niveau der Batterie zu einem Niveau über dem ersten vorgegebenen Niveau und außerhalb des SOC-Fensters zu drücken;
   iii) durch eine elektrische Maschine auf ein zweites vorgegebenes Niveau innerhalb des SOC-Fensters entladen wird;
- Laden und Entladen der Batterie wenigstens einmal innerhalb eines unteren Bereichs des SOC-Fensters, wobei die Batterie:
   i) während einer dritten Zeitspanne auf ein drittes vorgegebenes Niveau in dem SOC-Fenster geladen wird;
   ii) durch eine elektrische Maschine auf ein viertes vorgegebenes Niveau in dem SOC-Fenster entladen wird;
   iii) während einer vierten Zeitspanne durch einen zweiten Entladestromimpuls entladen wird, um das SOC-Niveau der Batterie auf ein Niveau unter dem vierten vorgegebenen Niveau und unter dem SOC-Fenster zu drücken;
- Kalibrieren einer Batterieverwaltungseinheit, die in dem Hybridfahrzeug enthalten ist, durch Verwenden der erreichten Niveaus außerhalb des SOC-Fensters, um korrekte obere und untere Ränder des derzeitigen SOC-Fensters zu bestimmen;
- Schätzen der SOH-Eigenschaften der Batterie während der Lade- und Entladeperioden durch Verwenden der Batterieverwaltungseinheit, um den Zustand der Batterie im Vergleich zu einer neuen und unbenutzten Batterie durch Vergleichen des derzeitigen SOC-Fensters mit einem standardmäßigen SOC-Fenster zu bestimmen;
wobei die erste und die dritte Zeitspanne länger als die zweite bzw. die vierte Zeitspanne sind; und das erste vorgegebene Niveau eine höhere Spannung repräsentiert als das zweite vorgegebene Niveau und das dritte vorgegebene Niveau eine höhere Spannung repräsentiert als das vierte vorgegebene Niveau.

Weitere relevante Dokumente sind: US 2012/296586 A1, WO 2009/158226 A2, US 9 244 132 B2, FR 3 044 773 A1 und US 6 366 054 B1.

Der Erfindung liegt das technische Problem zugrunde, ein verbessertes Verfahren zur Ermittlung der Restkapazität einer Batterie in einem Hybrid-Fahrzeug zur Verfügung zu stellen sowie eine geeignete Vorrichtung zu schaffen.

Die Lösung des technischen Problems ergibt sich durch ein Verfahren mit den Merkmalen des Anspruchs 1 sowie eine Vorrichtung mit den Merkmalen des Anspruchs 8. Weitere vorteilhafte Ausgestaltungen der Erfindung ergeben sich aus den Unteransprüchen.

Das Verfahren zur Ermittlung der Restkapazität einer Batterie in einem Hybrid-Fahrzeug, mittels einer Batterie, einer Elektromaschine und mindestens einer Steuereinheit, umfasst die folgenden Verfahrensschritte:
a) Ansteuern der Elektromaschine mittels der Steuereinheit in einem ersten Fahrzyklus derart, dass die Batterie auf einen vorgegebenen maximalen ersten Ladezustand SOC 1 geladen wird, wobei der maximale erste Ladezustand SOC 1 bis zur Beendigung des ersten Fahrzyklus beibehalten wird,
b) Beenden des ersten Fahrzyklus und Übergang in eine erste Standphase,
c) Durchführen einer ersten OCV-Messung nach einer vorgegebenen Wartezeit in der ersten Standphase,
d) Zuordnen eines SOC-Wertes des Messergebnisses der ersten OCV-Messung,
e) Entladen der Batterie auf einen vorgegebenen minimalen zweiten Ladezustand SOC 2, wobei der entnommene Strom aufintegriert wird,
f) Durchführen einer zweiten OCV-Messung nach einer vorgegebenen Wartezeit,
g) Zuordnen eines SOC-Wertes des Messergebnisses der zweiten OCV-Messung und
h) Bestimmen der Restkapazität der Batterie mittels der zugeordneten SOC-Werte der beiden OCV-Messungen und des Stromintegrals.

Hierdurch kann die Restkapazität erheblich genauer bestimmt werden, wobei das Verfahren insbesondere auch für Mild-Hybrid-Fahrzeuge geeignet ist. Dabei kann der erste Ladezustand SOC1 größer/gleich einem maximalen Ladezustand für den Normalbetrieb gewählt werden. Entsprechend kann der zweite Ladezustand SOC 2 kleiner/gleich einem minimalen Ladezustand für den Normalbetrieb gewählt werden., sodass der SOC-Hub entsprechend vergrößert wird. Die Wartezeit wird dabei so gewählt, dass die Relaxationsvorgänge in der Batterie abgeschlossen sind. Das Aufladen auf den ersten Ladezustand kann dabei ausschließlich durch Rekuperationsvorgänge erfolgen oder aber zusätzlich durch generatorischen Betrieb der Elektromaschine, die durch den Verbrennungsmotor angetrieben wird. Dabei sei angemerkt, dass SOC 1 und SOC 2 mit Spannungen korrespondieren, so dass das Laden auf SOC 1 und SOC 2 anhand eines Erreichens einer Spannung ermittelt wird.

In einer Ausführungsform werden die Verfahrensschritte e) - h) ebenfalls in der ersten Standphase durchgeführt, sodass nach einem Fahrzyklus und einer Standphase das Verfahren abgeschlossen ist.

In einer Ausführungsform erfolgt die Entladung der Batterie durch Ansteuerung elektrischer Verbraucher und/oder durch Laden einer Bordnetzbatterie über einen DC-DC-Wandler. Beispielsweise ist der elektrische Verbraucher eine Scheibenheizung. Der DC/DC-Wandler ist vorzugsweise bidirektional ausgebildet. Der Vorteil der Entladung über den DC/DC-Wandler ist, dass die Energie nur umgeladen wird, aber nicht verbraucht wird.

In einer alternativen Ausführungsform erfolgt der Verfahrensschritt e) in einem zweiten Fahrzyklus, wobei die Steuereinheit die Elektromaschine derart ansteuert, dass der vorgegebene zweite Ladezustand erreicht wird, wobei die Verfahrensschritte f) - h) in einer zweiten Standphase nach Beendigung des zweiten Fahrzyklus durchgeführt werden. Der Vorteil dieses Verfahrens ist, dass die elektrische Energie im Entladungsvorgang für den Antrieb genutzt werden kann. Nachteilig ist, dass die Bestimmung länger dauert.

In einer Ausführungsform wird das erfasste Stromintegral mittels mindestens einem Kriterium auf Vertrauenswürdigkeit überprüft, wobei bei Verletzung des mindestens einen Kriteriums das Verfahren zur Bestimmung der Restkapazität wiederholt wird. Ein Kriterium ist beispielsweise die zeitliche Länge eines Fahrzyklus. Ist dieser zu lang, so kann aufgrund zu vieler Lade- und Entladevorgänge der Wert des Stromintegrals zu ungenau sein.

In einer Ausführungsform wird der Ziel-SOC in der Steuereinheit beibehalten und in dem nächsten Fahrzyklus eingestellt, wenn ein Ziel-SOC während eines Fahrzyklus nicht erreicht wird, beispielsweise weil der Fahrzyklus zu kurz war.

In einer weiteren Ausführungsform legt die Steuereinheit die Betriebsstrategie in Abhängigkeit von Navigationsinformationen fest. So kann beispielsweise aus der Kenntnis des Streckenprofils der Beginn des Ladens oder Entladens optimiert werden, sodass beispielsweise möglichst lange während des Fahrzyklus die Hybrid-Funktionalität zur Verfügung steht und erst kurz vor Ende des Fahrzyklus die Batterie auf den Ziel-SOC geladen oder entladen wird.

Die Erfindung wird nachfolgend anhand bevorzugter Ausführungsbeispiels näher erläutert. Die Fig. zeigen:
- Fig. 1: ein schematische Blockschaltbild eines Hybridfahrzeuges,
- Fig. 2: ein schematisches Flussdiagramm eines ersten Verfahrens zur Bestimmung der Restkapazität einer Batterie und
- Fig. 3: ein schematisches Flussdiagramm eines zweiten Verfahrens zur Bestimmung der Restkapazität.

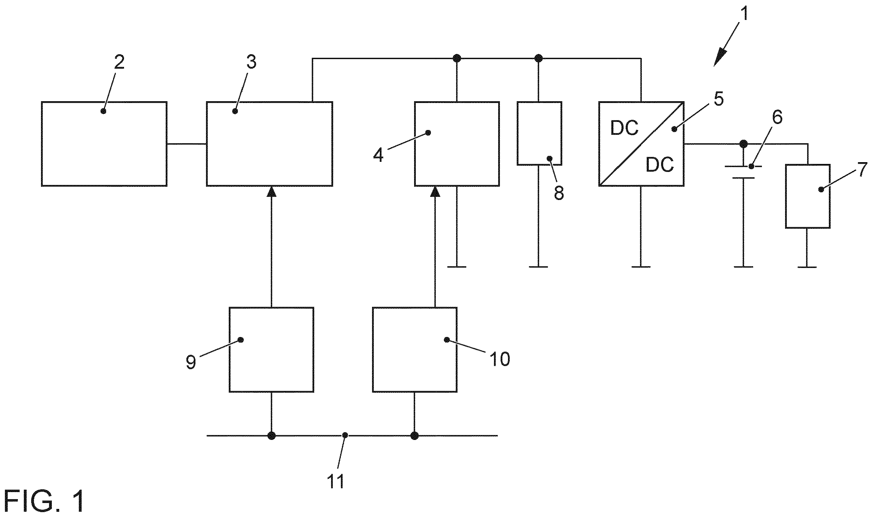

In der Fig. 1 ist ein schematische Blockschaltbild eines Hybrid-Fahrzeuges 1 dargestellt. Das Hybrid-Fahrzeug 1 umfasst eine Brennkraftmaschine 2, eine Elektromaschine 3, eine Batterie 4, einen DC/DC-Wandler 5, eine Bordnetzbatterie 6 sowie Bordnetzverbraucher 7. Optional können der Batterie 4 direkt weitere elektrische Verbraucher 8 zugeordnet sein. Weiter weist das Hybrid-Fahrzeug 1 eine Steuereinheit 9 sowie ein Batteriemanagementsteuergerät 10 auf. Die Nennspannung der Batterie 4 beträgt vorzugsweise 48 V und die Nennspannung der Bordnetzbatterie 6 beträgt vorzugsweise 12 V. Die Elektromaschine 3 kann im Boost-Betrieb die Brennkraftmaschine 2 in der Antriebsleistung unterstützen und im Rekuperationsbetrieb Bremsenergie speichern. Des Weiteren arbeitet die Elektromaschine 3 als Starter-Generator.

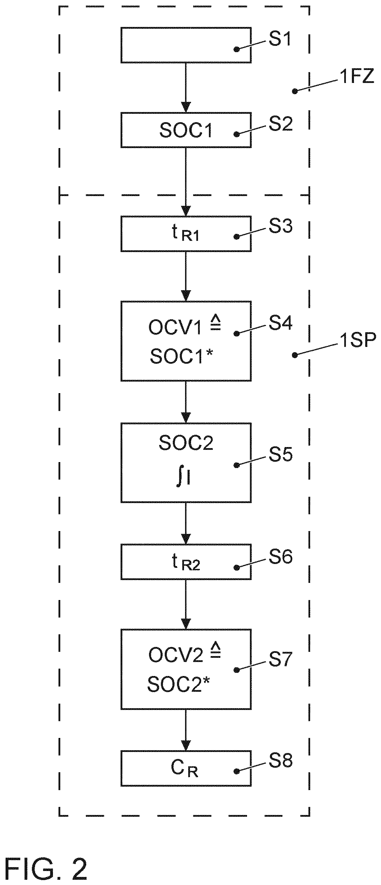

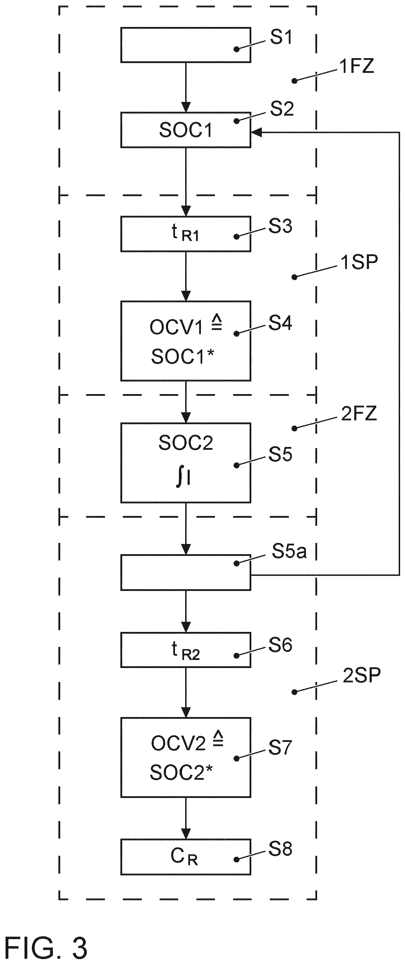

Das Verfahren zur Bestimmung der Restkapazität der Batterie 4 wird nun anhand der Fig. 2 und 3 näher erläutert.

In einem Schritt S 1 wird das Verfahren gestartet, wobei dies vorzugsweise durch das Batteriemanagementsteuergerät 10 während eines ersten Fahrzyklus 1FZ erfolgt. Das Startsignal wird beispielsweise über einen Fahrzeugbus 11 an die Steuereinheit 9 übertragen. Die Steuereinheit 9 steuert dann die Elektromaschine 3 derart in einem zweiten Verfahrensschritt S2 an, dass die Batterie 4 auf einen vorgegebenen maximalen Ladezustand SOC 1 aufgeladen wird. Dieser Ladezustand SOC 1 wird bis zum Ende des ersten Fahrzyklus 1FZ gehalten. Anschließend wird der erste Fahrzyklus 1FZ beendet und das Hybrid-Fahrzeug 1 wechselt in eine erste Standphase 1SP. In einem dritten Verfahrensschritt S3 wird eine vorgegebene Wartezeit t_{R1} gewartet, bis Relaxationsvorgänge in der Batterie 4 abgeschlossen sind. Anschließend wird in einem weiteren Verfahrensschritt S4 eine erste OCV-Messung OCV 1 durchgeführt und der gemessenen Spannung ein SOC-Wert SOC1* zugeordnet. In einem fünften Verfahrensschritt S5 wird dann die Batterie 4 auf einen zweiten vorgegebenen minimalen zweiten Ladezustand SOC 2 entladen, indem der DC/DC-Wandler 5 angesteuert wird, um die Batterie 4 durch Laden der Bordnetzbatterie 6 sowie Leistungsaufnahme ausgewählter Bordnetzverbraucher 7 zu entladen. Alternativ oder ergänzend wird die Batterie 4 durch den Verbraucher 8 entladen. Dabei wird der Strom I aus der Batterie 4 gemessen und aufintegriert. Im Verfahrensschritt S6 wird wieder eine Wartezeit t_{R2} gewartet, bis in einem Verfahrensschritt S7 eine zweite OCV-Messung OCV 2 durchgeführt wird und ein SOC-Wert SOC2* zugeordnet wird. Schließlich wird im Verfahrensschritt S8 die Restkapazität C_{R} aus SOC1*, SOC2* und dem Stromintegral ∫ I bestimmt. Die neue Restkapazität C_{R} wird dann im Batteriemanagementsteuergerät 10 abgespeichert.

In der Fig. 3 ist ein alternatives Verfahren dargestellt, wobei viele Verfahrensschritte gleich sind und nur zu anderen Zeitpunkten erfolgen, wobei gleiche Verfahrensschritte mit gleichen Bezugszeichen versehen sind. Dabei erfolgen die Verfahrensschritte S1 - S2 wie zuvor im ersten Fahrzyklus 1FZ. Die Verfahrensschritte S3 - S4 erfolgen in der ersten Standphase 1SP. Im Gegensatz zum ersten Verfahren erfolgt der Verfahrensschritt S5 in einem zweiten Fahrzyklus 2FZ, wobei die Verfahrensschritte S6 - S8 in einer zweiten Standphase 2SP erfolgen. Zusätzlich ist dem Verfahrensschritt S6 ein Verfahrensschritt S5a vorgeschaltet. In dem Verfahrensschritt S5a wird das Stromintegral aus Verfahrensschritt S5 auf Vertrauenswürdigkeit anhand mindestens eines Kriteriums überprüft, wobei bei positiver Überprüfung mit Verfahrensschritt S6 fortgefahren wird und ansonsten das Verfahren mit dem Verfahrensschritt S2 neu gestartet wird.

### Bezugszeichenliste

- 1): Hybrid-Fahrzeug
- 2): Brennkraftmaschine
- 3): Elektromaschine
- 4): Batterie
- 5): DC/DC-Wandler
- 6): Bordnetzbatterie
- 7): Bordnetzverbraucher
- 8): weitere elektrische Verbraucher
- 9): Steuereinheit
- 10): Batteriemanagementsteuergerät
- 11): Fahrzeugbus
- C_{R}: Restkapazität
- 1FZ: Fahrzyklus
- 2FZ: Fahrzyklus
- I: Strom
- ∫ I: Stromintegral
- SOC1: erster Ladezustand
- SOC2: zweiter Ladezustand
- 1SP: erste Standphase
- 2SP: zweite Standphase
- t_{R1}: Wartezeit
- t _{R2}: Wartezeit

## Patentansprüche

1. Verfahren zur Ermittlung der Restkapazität (C_{R}) einer Batterie (4) für ein Hybrid-Fahrzeug (1), mittels einer Batterie (4), einer Elektromaschine (3) und mindestens einer Steuereinheit (9),
umfassend die folgenden Verfahrensschritte:
a) Ansteuern der Elektromaschine (3) mittels der Steuereinheit (9) in einem ersten Fahrzyklus (1FZ) derart, dass die Batterie (4) auf einen vorgegebenen maximalen ersten Ladezustand SOC 1 geladen wird, wobei der maximale erste Ladezustand SOC 1 bis zur Beendigung des ersten Fahrzyklus (1FZ) beibehalten wird,
b) Beenden des ersten Fahrzyklus (1FZ) und Übergang in eine erste Standphase (1SP),
c) Durchführen einer ersten OCV-Messung (OCV1) nach einer vorgegebenen Wartezeit (t_{R1}) in der ersten Standphase (1SP),
d) Zuordnen eines SOC-Wertes (SOC1*) dem Messergebnis der ersten OCV-Messung,
e) Entladen der Batterie auf einen vorgegebenen minimalen zweiten Ladezustand SOC 2, wobei der entnommene Strom (I) aufintegriert wird,
f) Durchführen einer zweiten OCV-Messung (OCV2) nach einer vorgegebenen Wartezeit (t_{R2}),
g) Zuordnen eines SOC-Wertes (SOC2*) dem Messergebnis der zweiten OCV-Messung und
h) Bestimmen der Restkapazität (C_{R}) der Batterie (4) mittels der zugeordneten SOC-Werte (SOC1*, SOC2*) der beiden OCV-Messungen (OCV1, OCV2) und des Stromintegrals.

2. Verfahren nach Anspruch 1, **dadurch gekennzeichnet, dass** die Verfahrensschritte e) - h) in der ersten Standphase (1SP) erfolgen.

3. Verfahren nach Anspruch 2, **dadurch gekennzeichnet, dass** die Entladung der Batterie (4) durch Ansteuerung elektrischer Verbraucher (7, 8) und/oder durch Laden einer Bordnetzbatterie (6) über einen DC/DC-Wandler (5) erfolgt.

4. Verfahren nach Anspruch 1, **dadurch gekennzeichnet, dass** der Verfahrensschritt e) in einem zweiten Fahrzyklus (2FZ) erfolgt, wobei die Steuereinheit (9) die Elektromaschine (3) derart ansteuert, dass der vorgegebene zweite Ladezustand SOC 2 erreicht wird, und Durchführen der Verfahrensschritte f) - h) in einer zweiten Standphase (2SP) nach Beendigung des zweiten Fahrzyklus (2FZ) erfolgt.

5. Verfahren nach Anspruch 4, **dadurch gekennzeichnet, dass** das erfasste Stromintegral mittels mindestens einem Kriterium auf Vertrauenswürdigkeit überprüft wird, wobei bei Verletzung des mindestens einen Kriteriums das Verfahren zur Bestimmung der Restkapazität (C_{R}) wiederholt wird.

6. Verfahren nach einem der vorangegangenen Ansprüche, **dadurch gekennzeichnet, dass**, wenn ein Ziel-SOC während eines Fahrzyklus (FZ) nicht erreicht wird, der Ziel-SOC in der Steuereinheit (9) beibehalten und in dem nächsten Fahrzyklus (FZ) eingestellt wird.

7. Verfahren nach einem der vorangegangenen Ansprüche, **dadurch gekennzeichnet, dass**, die Steuereinheit (9) die Betriebsstrategie in Abhängigkeit von Navigationsinformationen festlegt.

8. Vorrichtung zur Ermittlung der Restkapazität (CR) einer Batterie (4) für ein Hybrid-Fahrzeug (1), umfassend eine Batterie (4), eine Elektromaschine (3) und mindestens eine Steuereinheit (9),
**dadurch gekennzeichnet, dass**
die Steuereinheit (9) derart ausgebildet ist, ein Verfahren nach den Merkmalen des Anspruchs 1 durchzuführen.

9. Vorrichtung nach Anspruch 8, **dadurch gekennzeichnet, dass** das Hybrid-Fahrzeug (1) ein Mild-Hybrid-Fahrzeug ist.

## Claims

1. Method for determining the remaining capacity (C_{R}) of a battery (4) for a hybrid vehicle (1), by means of a battery (4), an electric machine (3) and at least one control unit (9),
comprising the following method steps:
a) controlling the electric machine (3) by means of the control unit (9) in a first driving cycle (1FZ) in such a way that the battery (4) is charged to a predefined maximum first state of charge SOC 1, the maximum first state of charge SOC 1 being maintained until the end of the first driving cycle (1FZ),
b) ending the first driving cycle (1FZ) and transitioning to a first stationary phase (1SP),
c) carrying out a first OCV measurement (OCV1) after a predefined waiting time (t_{R1}) in the first stationary phase (1SP),
d) assigning a SOC value (SOC1*) to the measurement result of the first OCV measurement,
e) discharging the battery to a predefined minimum second state of charge SOC 2, the drawn current (I) being integrated,
f) carrying out a second OCV measurement (OCV2) after a predefined waiting time (t_{R2}),
g) assigning a SOC value (SOC2*) to the measurement result of the second OCV measurement, and
h) ascertaining the remaining capacity (C_{R}) of the battery (4) by means of the assigned SOC values (SOC1*, SOC2*) of the two OCV measurements (OCV1, OCV2) and the current integral.

2. Method according to Claim 1, **characterized in that** method steps e) - h) take place in the first stationary phase (1SP).

3. Method according to Claim 2, **characterized in that** the battery (4) is discharged by control of electrical consumers (7, 8) and/or by charging of an onboard electrical system battery (6) via a DC/DC converter (5).

4. Method according to Claim 1, **characterized in that** method step e) takes place in a second driving cycle (2FZ), the control unit (9) controlling the electric machine (3) in such a way that the predefined second state of charge SOC 2 is attained, and method steps f) - h) are carried out in a second stationary phase (2SP) after the end of the second driving cycle (2FZ).

5. Method according to Claim 4, **characterized in that** the detected current integral is checked for trustworthiness by means of at least one criterion, the method for ascertaining the remaining capacity (C_{R}) being repeated in the event of the at least one criterion being violated.

6. Method according to any of the preceding claims, **characterized in that** if a target SOC is not attained during a driving cycle (FZ), the target SOC is maintained in the control unit (9) and is set in the next driving cycle (FZ).

7. Method according to any of the preceding claims, **characterized in that** the control unit (9) defines the operating strategy depending on navigation information.

8. Device for determining the remaining capacity (CR) of a battery (4) for a hybrid vehicle (1), comprising a battery (4), an electric machine (3) and at least one control unit (9),
**characterized in that**
the control unit (9) is configured in such a way as to carry out a method according to the features of Claim 1.

9. Device according to Claim 8, **characterized in that** the hybrid vehicle (1) is a mild hybrid vehicle.

## Revendications

1. Procédé de détermination de la capacité restante (C_{R}) d'une batterie (4) pour un véhicule hybride (1), au moyen d'une batterie (4), d'une machine électrique (3) et d'au moins une unité de commande (9),
comprenant les étapes suivantes :
a) commande de la machine électrique (3) au moyen de l'unité de commande (9) dans un premier cycle de conduite (1FZ) de telle sorte que la batterie (4) soit chargée à un premier état de charge maximal SOC 1 prédéfini, le premier état de charge maximal SOC 1 étant maintenu jusqu'à la fin du premier cycle de conduite (1FZ),
b) terminaison du premier cycle de conduite (1FZ) et transition dans une première phase d'arrêt (1SP),
c) réalisation d'une première mesure d'OCV (OCV1) après un temps d'attente (t_{R1}) prédéfini dans la première phase d'arrêt (1SP),
d) association d'une valeur de SOC (SOC1*) au résultat de mesure de la première mesure d'OCV,
e) décharge de la batterie à un deuxième niveau de charge minimal SOC 2 prédéfini, l'intégrale du courant (I) prélevé étant calculée,
f) réalisation d'une deuxième mesure d'OCV (OCV2) après un temps d'attente (t_{R2}) prédéfini,
g) association d'une valeur de SOC (SOC2*) au résultat de mesure de la deuxième mesure d'OCV et
h) détermination de la capacité restante (C_{R}) de la batterie (4) au moyen des valeurs de SOC (SOC1*, SOC2*) associées des deux mesures d'OCV (OCV1, OCV2) et de l'intégrale du courant.

2. Procédé selon la revendication 1, **caractérisé en ce que** les étapes e) - h) du procédé sont effectuées dans la première phase d'arrêt (1SP).

3. Procédé selon la revendication 2, **caractérisé en ce que** la décharge de la batterie (4) est effectuée en commandant des consommateurs électriques (7, 8) et/ou en chargeant une batterie de réseau de bord (6) par le biais d'un convertisseur CC/CC (5).

4. Procédé selon la revendication 1, **caractérisé en ce que** l'étape e) est effectuée dans un deuxième cycle de conduite (2FZ), l'unité de commande (9) commandant la machine électrique (3) de telle sorte que le deuxième niveau de charge SOC 2 prédéfini est atteint, et la réalisation des étapes f) - h) s'effectuant dans une deuxième phase d'arrêt (2SP) après avoir terminé le deuxième cycle de conduite (2FZ).

5. Procédé selon la revendication 4, **caractérisé en ce que** la crédibilité de l'intégrale de courant acquise est vérifiée au moyen d'au moins un critère, le procédé de détermination de la capacité restante (C_{R}) étant répété en cas de violation de l'au moins un critère.

6. Procédé selon l'une des revendications précédentes, **caractérisé en ce que** lorsqu'un SOC cible n'est pas atteint pendant un cycle de conduite (FZ), le SOC cible est maintenu dans l'unité de commande (9) et réglé dans le cycle de conduite (FZ) suivant.

7. Procédé selon l'une des revendications précédentes, **caractérisé en ce que** l'unité de commande (9) fixe la stratégie de fonctionnement en fonction d'informations de navigation.

8. Dispositif de détermination de la capacité restante (C_{R}) d'une batterie (4) pour un véhicule hybride (1), comprenant une batterie (4), une machine électrique (3) et au moins une unité de commande (9),
**caractérisé en ce que**
l'unité de commande (9) est configurée pour mettre en œuvre un procédé selon les caractéristiques de la revendication 1.

9. Dispositif selon la revendication 8, **caractérisé en ce que** le véhicule hybride (1) est un véhicule hybride léger (« mild-hybrid »).
